# EUROPÄISCHE PATENTSCHRIFT

(11) **EP 3 688 853 B1**
(45) Veröffentlichungstag und Bekanntmachung des Hinweises auf die Patenterteilung: **07.06.2023**
(21) Anmeldenummer: 18717619.3
(22) Anmeldetag: 13.04.2018
(51) Int. Cl.: H02H 3/06, G05F 1/56, H02H 3/08, H02H 9/02, H02H 3/02, H02H 3/027

(54) **ELEKTRONISCHER SCHUTZSCHALTER UND VERFAHREN ZU DESSEN BETRIEB**
ELECTRONIC CIRCUIT BREAKER AND METHOD FOR OPERATING SAME
DISJONCTEUR ÉLECTRONIQUE ET SON PROCÉDÉ DE FONCTIONNEMENT

(30) Priorität: 27.09.2017 DE 102017217232
(43) Veröffentlichungstag der Anmeldung: 05.08.2020
(73) Patentinhaber: Ellenberger & Poensgen GmbH, 90518 Altdorf (DE)
(72) Erfinder: ASANZA MALDONADO, Diego Fernando, 68161 Mannheim (DE)
(74) Vertreter: FDST Patentanwälte
(86) Internationale Anmeldenummer: PCT/EP2018/059590
(87) Internationale Veröffentlichungsnummer: WO 2019/063138

(56) Entgegenhaltungen:
- DE-T2- 60 130 164
- US-A- 5 943 203
- US-A1- 2015 026 486

## Beschreibung

Die Erfindung betrifft einen elektronischen Schutzschalter und ein Verfahren zu dessen Betrieb.

Strombegrenzende elektronische Schutzschalter weisen typischerweise einen MOSFET (Metall-Oxid-Halbleiter-Feldeffekttransistor) als ein Halbleiterschalter, also einem Element mit variablem elektrischen Widerstand auf, um einen durch einen Verbraucher fließenden Strom (Verbraucherstrom) in einem Störfall, wie beispielsweise einem Kurzschluss oder einer Überlast, konstant zu halten.

Insbesondere wird dabei der MOSFET mit einer vergleichsweise schnell schaltenden Strombegrenzungsschaltung gekoppelt, um eine Konstantstromquelle zu realisieren. Insbesondere vergleicht die Strombegrenzungsschaltung den nachfolgend auch als Verbraucherstrom bezeichneten Laststrom, insbesondere dessen Stromstärke, mit einem vorgegebenen Soll-Wert, und ändert die Gate-Spannung des MOSFETS entsprechend, um den Stromfluss, insbesondere den Verbraucherstrom, konstant zu halten.

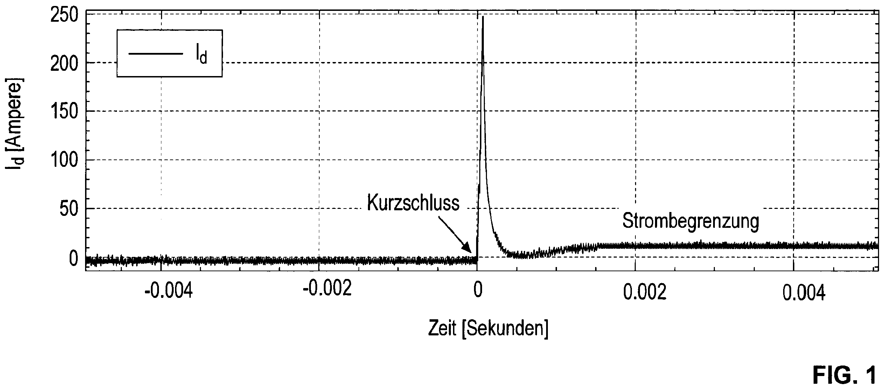

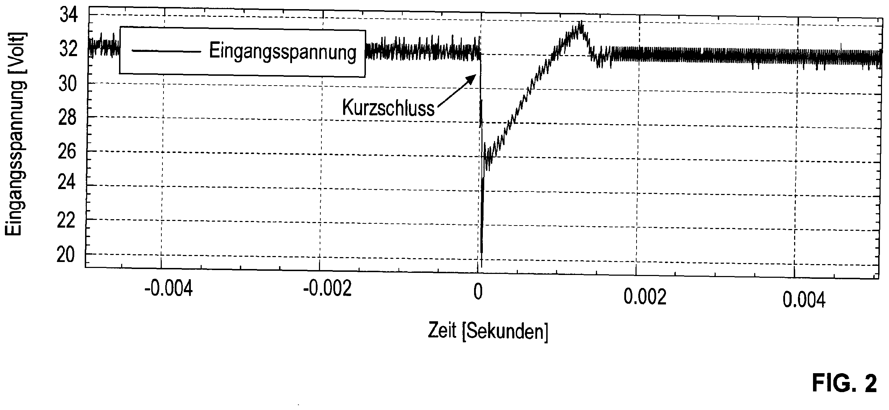

Typischerweise ist die Stromstärke des Verbraucherstroms geringer als der vorgegebene Soll-Wert. Aufgrund dessen nimmt die Gate-Spannung zu, so dass der MOSFET gesättigt ist. Im Störfall wird der Verbraucherstrom mittels der Strombegrenzungsschaltung begrenzt. Beispielsweise zeigt Fig. 1 einen zeitlichen Verlauf eines Verbraucherstroms gemäß diesem Stand der Technik, wobei zum Zeitpunkt t = 0 ein Kurzschluss stattfindet. Der Verbraucher-/Laststrom ist hier mit I_{d} bezeichnet. Dabei vergeht, insbesondere bedingt durch die Bauart der Strombegrenzungsschaltung, eine endliche (Reaktions-)Zeit zwischen dem Einsetzen des, insbesondere in der Last auftretenden, Störfalls und der Ausgabe eines Schaltsignals bzw. eines Steuersignals. Diese Verzögerung äußert sich bei Einsetzen des Störfalls als eine Stromspitze des Verbraucherstroms. Dabei weist der Verbraucherstrom bei einem Kurzschluss beispielsweise eine Stromstärke von mehreren Hundert Ampere auf, wobei eine zeitliche Dauer der Stromspitze insbesondere von der Reaktionszeit der Strombegrenzungsschaltung abhängt. Beispielsweise fällt der MOSFET bei einer vergleichsweise langsamen Reaktionszeit der Strombegrenzungsschaltung aus, und es können wie in Fig. 2 dargestellt, zusätzlich Störungen der Versorgungsspannung der Stromquelle bzw. der Eingangsspannung hervorgerufen werden, welche in Fig. 2 als "Input Voltage" bezeichnet ist.

Insbesondere ist eine Verbesserung der Reaktionsgeschwindigkeit der Strombegrenzungsschaltung mit der Verwendung vergleichsweise kostenaufwändiger Komponenten verbunden und reduziert eine Stabilität des Regelkreises (der Strombegrenzungsschaltung). Aufgrund dessen oszilliert beispielsweise das von der Strombegrenzungsschaltung ausgegebene Signal und somit der Laststrom bei einer sich ändernden Lastbedingung insbesondere unerwünscht.

Um strombegrenzende elektronische Schutzschalter bei vergleichsweise unterschiedlichen Lastbedingungen verwenden zu können, werden typischerweise eine Strombegrenzungsschaltung, insbesondere mit einer hinreichenden Reaktionszeit, sowie ein MOSFET verwendet, welcher den Stromspitzen ausreichend Rechnung trägt. Insbesondere tritt dabei jedoch weiterhin eine Instabilität im Regelkreis auf. Des Weiteren kann der MOSFET überdimensioniert ausgelegt werden, was nachteilig wiederum Kosten erhöht.

Aus der US 5 943 203 A ist ein monolithischer elektronischer Leistungsschalter mit einem Eingangsanschluss, einem Ausgangsanschluss und einer steuerbaren Impedanz, die zwischen den Eingangs- und Ausgangsanschlüssen angeschlossen sind, bekannt. Dabei erzeugt ein Stromsensor ein Stromstärkensignal, das den zwischen den Eingangs- und Ausgangsanschlüssen fließenden Strom anzeigt. In einer Ausführungsform erzeugt eine Überstromschaltung ein Überstromsignal, wenn das Stromgrößen-Signal einen Schwellenwert überschreitet. In Reaktion auf mindestens ein erstes Auftreten des Überstromsignals steuert eine Steuerschaltung die steuerbare Impedanz, um den Strom durch die steuerbare Impedanz für einen Zeitraum zu reduzieren und dann automatisch den Strom durch die steuerbare Impedanz zu erhöhen.

In der US 2015/026486 A1 ist eine Überstromschutzschaltung für einen Server beschrieben. Diese ist zwischen einem Stromversorgungsmodul und einer Last auf einem Mainboard geschaltet und umfasst eine Erfassungskomponente, eine Erfassungseinheit, eine Vergleichseinheit und einen Stromschalter. Die Erfassungskomponente ist zwischen dem Stromversorgungsmodul und der Erfassungseinheit geschaltet. Die Erfassungseinheit erfasst eine Spannung, die von der Erfassungskomponente als Reaktion auf einen Versorgungsstrom erzeugt wird. Die Vergleichseinheit erzeugt eine Steuerspannung entsprechend der Erfassungsspannung und einer Referenzspannung. Der Stromschalter ist zwischen der Erfassungskomponente und der Last geschaltet und wird durch die Steuerspannung gesteuert. Wenn die Vergleichseinheit feststellt, dass die Erfassungsspannung größer als die Referenzspannung ist, unterbricht die Vergleichseinheit den Netzschalter, um einen Stromversorgungspfad zwischen dem Stromversorgungsmodul und der Last zu trennen.

In der DE 601 30 164 T2 ist eine Vorrichtung zum Schützen einer elektrischen Last vor einem übermäßigen Strom offenbart. Diese weist einen Halbleiterschalter zum Verbinden der elektrischen Last mit einer Stromquelle auf, wobei der Schalter einen Kontrolleingang aufweist. Weiterhin weist die Vorrichtung einem Stromsensor, der mit dem Halbleiterschalter gekoppelt ist und ein Sensorsignal erzeugt, welches indikativ für die Stärke des zu der elektrischen Last fließenden Stromes ist sowie eine Steuerschaltung auf. Die Steuerschaltung hat einen ersten Betriebsmodus hat, wenn die Stromstärke geringer als ein erster Schwellwert ist, wobei der Halbleiterschalter in einem kontinuierlich leitenden Zustand gehalten wird, einen zweiten Betriebsmodus, wenn die Stromstärke größer als der erste Schwellwert und kleiner als ein zweiter Schwellwert ist, wobei der Halbleiterschalter nach einer vorbestimmten Zeitdauer nicht-leitend geschaltet wird, und einen dritten Betriebsmodus, wenn die Stromstärke größer als der zweite Schwellwert ist, wobei der Halbleiterschalter alternierend leitend und nicht-leitend gepulst wird, um den Strom durch die Last auf weniger als den zweiten Schwellwert zu begrenzen.

Der Erfindung liegt die Erfindung zugrunde, einen geeigneten elektronischen Schutzschalter anzugeben, mittels welchem eine Last gegen eine Überlast oder einen Kurzschluss geschützt ist. Zudem soll ein Verfahren zu dessen Betrieb angegeben werden.

Diese Aufgabe wird bezüglich des elektronischen Schutzschalters erfindungsgemäß gelöst durch die Merkmale des Anspruchs 1. Bezüglich des Verfahrens wird die Aufgabe erfindungsgemäß gelöst durch die Merkmale des Anspruchs 6. Vorteilhafte Ausgestaltungen und Weiterbildungen sind Gegenstand der Unteransprüche. Dabei gelten die Ausführungen im Zusammenhang mit dem elektronischen Schutzschalter sinngemäß auch für das Verfahren und umgekehrt.

Hierzu umfasst der Schutzschalter einen ersten Halbleiterschalter, der in einem Strompfad zwischen einem Spannungseingang und einem Lastausgang geschaltet ist, und eine mit dem Steuereingang des ersten Halbleiterschalters verbundene Steuervorrichtung. Dabei ist der erste Halbleiterschalter in Abhängigkeit eines der Steuervorrichtung zugeführten Ist-Wertes des Laststroms angesteuert. Zudem ist die Steuervorrichtung dabei zur Strombegrenzung sowie zum Abschalten des ersten Halbleiterschalters, also zur stromsperrenden Schalten (Stromsperrung) des Halbleiterschalters, eingerichtet.

Vorzugsweise weist der elektronische Schutzschalter zur Erfassung des Laststroms, insbesondere dessen Stromstärke, und zur Bereitstellung des Ist-Wertes des Laststroms einen Stromsensor auf, der in den Strompfad geschaltet ist. geeigneterweise ist der Stromsensor dabei in Serie zum ersten Halbleiterschalter in den Strompfad geschaltet. Vorzugsweise gibt der Stromsensor den Ist-Wert, welcher insbesondere den Laststrom repräsentiert, der Steuervorrichtung als eine Spannung oder als einen Spannungswert zu.

Mit anderen Worten weist die Steuervorrichtung eine Einrichtung und/oder eine Schaltung zur Strombegrenzung sowie eine Einrichtung und/oder eine Schaltung zum Abschalten bzw. zur Stromsperrung des ersten Halbleiterschalters auf. Mit anderen Worten wird insbesondere der Laststrom mittels der Einrichtung und/oder der Schaltung zur Strombegrenzung, insbesondere aktiv, d.h. mittels eines Steuervorgangs, beschränkt (begrenzt). Insbesondere wird des Weiteren mittels der Einrichtung und/oder der Schaltung zum Abschalten und/oder zur Stromsperrung des Laststroms bei Bedarf im Störfall der Laststrom, gesperrt, d.h. der Stromkreis wird unterbrochen, so dass ein Strom mittels des Abschaltens und/oder der Stromsperrung verhindert ist.

Der erste Halbleiterschalter wird also in Abhängigkeit eines den Laststrom repräsentierenden Ist-Wertes, welcher insbesondere vom Stromsensor bestimmt und ausgegeben wird, angesteuert. Dabei wird der Ist-Wert der Steuervorrichtung, der Einrichtung bzw. Schaltung zur Strombegrenzung und/oder der Einrichtung bzw. Schaltung zum Abschalten zugeführt. Die Einrichtung bzw. Schaltung zur Strombegrenzung und/oder die Einrichtung bzw. Schaltung zum Abschalten ist dabei zweckmäßigerweise ausgangsseitig mit dem Steuereingang des ersten Halbleiterschalters verbunden.

Die Steuervorrichtung weist eine Steuereinheit auf. Beispielsweise ist die Steuereinheit als ein der Einrichtung bzw. Schaltung zur Strombegrenzung und der Einrichtung bzw. Schaltung zum Abschalten gemeinsames Bauteil ausgeführt. Alternativ weist die Einrichtung bzw. Schaltung zur Strombegrenzung und die Einrichtung bzw. Schaltung zum Abschalten jeweils eine Steuereinheit auf. Beispielsweise ist die Steuereinheit ein Mikrokontroller, vorzugsweise ein Mikroprozessor.

Vorzugsweise vergleicht die Steuervorrichtung bzw. die Steuereinheit den dieser zugeführten Ist-Wert mit einem vorgegebenen, vorgebbaren, eingestellten und/oder einstellbaren Maximalwert. Die Steuervorrichtung bzw. die Steuereinheit gibt bei Überschreiten des Maximalwertes durch den Ist-Wert ein Signal, insbesondere ein Abschaltsignal, an die Einrichtung bzw. Schaltung zum Abschalten des ersten Halbleiterschalters, im Folgenden kurz als "Abschaltschaltung" bezeichnet, und alternativ oder vorzugsweise zusätzlich an die Einrichtung bzw. Schaltung zur Strombegrenzung des ersten Halbleiterschalters, im Folgenden kurz als "Strombegrenzungsschaltung" bezeichnet, aus. Der Maximalwert repräsentiert dabei insbesondere einen Schwellenwert, bei dessen überschreiten ein Kurzschlussfall angenommen ist bzw. vorliegt. Mit anderen Worten repräsentiert der Maximalwert einen Kurzschlussstrom.

Weiterhin wird der Steuervorrichtung bzw. der Strombegrenzungsschaltung eingangsseitig der Ist-Wert zugeführt. Zusätzlich wird der Strombegrenzungsschaltung eingangsseitig, insbesondere von der Steuereinheit, ein Nominal-Soll-Wert zugeführt, welcher der Steuervorrichtung, insbesondere der Steuereinheit, vorgegeben, vorgebbar und/oder an der Steuervorrichtung bzw. an der Steuereinheit, eingestellt und/oder einstellbar ist. Der Nominal-Soll-Wert repräsentiert dabei insbesondere einen Betrag einer Stromstärke, auf welche der Laststrom bei Strombegrenzung begrenzt ist bzw. wird.

In geeigneter Weiterbildung ist oder wird der erste Halbleiterschalter, insbesondere mittels der Strombegrenzungsschaltung, in Abhängigkeit des Ist-Wertes und des Nominal-Soll-Wertes strombegrenzend angesteuert. Insbesondere wird der erste Halbleiterschalter bei Überschreiten des Nominal-Soll-Wertes durch den Ist-Wert strombegrenzend angesteuert, auch sofern der Maximalwert Iₛₕₒᵣₜ nicht überschritten ist.

Hierzu weist die Strombegrenzungsschaltung ein Einstellglied auf. Dabei wird bzw. ist insbesondere dem Einstellglied eingangsseitig der Nominal-Soll-Wert, insbesondere von der Steuervorrichtung, vorzugsweise von der Steuereinheit, zugeführt und/oder zuführbar. Des Weiteren gibt das Einstellglied ausgangsseitig einen Soll-Wert aus. Mit anderen Worten wird hier mittels des Einstellglieds ein sich aus dem Nominal-Soll-Wert ergebender Soll-Wert ausgegeben. Insbesondere wird der erste Halbleiterschalter in Abhängigkeit dieses Soll-Werts und des Ist-Wertes, insbesondere einer Differenz des Soll-Wertes und des Ist-Wertes, strombegrenzend angesteuert.

Dabei weist das Einstellglied einen Kondensator auf, wobei beispielsweise die an diesem anliegende Spannung als Ausgangssignal des Einstellglieds dient. Dieser Kondensator ist über einem Schalter in einer ersten Schalterstellung mit der Steuervorrichtung insbesondere zur Zuführung des Nominal-Soll-Werts bzw. einen diesen repräsentierenden Spannungswert, gekoppelt. In einer zweiten Schalterstellung wird bzw. ist der Kondensator entladen, wozu der Kondensator mittels des Schalters in der zweiten Schalterstellung beispielsweise auf ein Bezugspotenzial, beispielsweise Ground, gelegt ist.

Zusammenfassend ist mittels des Schalters eine am Kondensator anliegende Spannung entsprechend geändert oder änderbar, welche als das Ausgangssignal des Einstellglieds herangezogen wird.

Des Weiteren weist die Strombegrenzungsschaltung in vorteilhafter Weiterbildung einen Operationsverstärker auf. Dabei ist an dessen ersten Eingang das Einstellglied zum Zuführen des Soll-Werts angeschlossen und an dessen zweiten Eingang, beispielsweise dessen invertierenden Eingang, ist der Ist-Wert zugeführt. Alternativ ist am zweiten Eingang der Nominal-Soll-Wert zugeführt, insbesondere sofern die Einrichtung bzw. Schaltung zur Strombegrenzung kein Einstellglied aufweist. Mittels des Operationsverstärkers wird in geeigneter Ausgestaltung ein Steuersignal zum Ansteuern des Halbleiterschalters, insbesondere eine Differenz aus dem Soll-Wert und dem Ist-Wert gebildet, welches insbesondere zur Strombegrenzung dient. Beispielsweise kann zusätzlich ein gegenkoppelnder Kondensator an den Operationsverstärker unter Bildung eines Integrators (Integrierers) geschaltet sein, wobei dann insbesondere ein Steuersignal aus einem Integral der Differenz über die Zeit gebildet wird.

Vorzugsweise wird der Steuervorrichtung bzw. der Steuereinheit eine an der Last anliegende Spannung (Lastspannung), oder alternativ ein die Lastspannung repräsentierendes Lastspannungssignal, zugeführt. Beispielsweise kann mittels der Lastspannung bzw. dem Lastspannungssignal und dem der Steuervorrichtung bzw. der Steuereinheit zugeführten Ist-Wert eine der Last zugeführte Leistung bestimmt werden.

Vorzugsweise weist die Steuervorrichtung, die Strombegrenzungsschaltung und/oder die Abschaltschaltung einen zweiten Halbleiterschalter auf. Beispielsweise ist der zweite Halbleiterschalter als ein der Strombegrenzungsschaltung und der Abschaltschaltung gemeinsames Bauteil ausgebildet. Vorzugsweise ist dieser zweite Halbleiterschalter dabei als ein pnp-Bipolartransistor ausgeführt.

Vorzugweise ist der zweite Halbleiterschalter des Weiteren ausgangsseitig der Steuervorrichtung, der Strombegrenzungsschaltung und/oder der Abschaltschaltung angeordnet und an den Steuereingang des ersten Halbleiterschalters angeschlossen. Beispielsweise ist der zweite Halbleiterschalter emitterseitig (ausgangsseitig) an den Steuereingang des ersten Halbleiterschalters angeschlossen. Insbesondere bildet der Ausgang des zweiten Halbleiterschalters somit einen Ausgang der Strombegrenzungsschaltung bzw. der Abschaltschaltung. Sofern der zweite Halbleiterschalter als ein der Strombegrenzungsschaltung und/oder der Abschaltschaltung gemeinsames Bauteil ausgebildet ist, dient der zweite Halbleiterschalter vorzugsweise sowohl zur abschaltenden bzw. stromsperrenden als auch zur strombegrenzenden Ansteuerung des ersten Halbleiterschalters.

Vorzugsweise ist dabei dessen Basis, d.h. eingangsseitig des zweiten Halbleiterschalters, an weitere Komponenten der Einrichtung bzw. Schaltung zur Strombegrenzung und an die Einrichtung bzw. Schaltung zum Abschalten angeschlossen, wobei die Einrichtung bzw. Schaltung zur Strombegrenzung und die Einrichtung bzw. Schaltung zum Abschalten beispielsweise parallel an der Basis angeschlossen sind.

Vorzugsweise ist der erste Halbleiterschalter ein N-Kanal-MOS-Transistor (NMOS, NMOSFET). Vorzugsweise ist dieser dabei drain-seitig am Spannungseingang, source-seitig am Lastausgang und gate-seitig, d.h. mit dessen Steuereingang, an der Steuervorrichtung angeschlossen. Insbesondere ist der erste Halbleiterschalter unter Bildung einer spannungsgesteuerten Stromquelle verschaltet, d.h. in eine entsprechende spannungsgesteuerte Stromquellenschaltung integriert, wobei deren Ausgangsstrom (Laststrom) mittels der Steuervorrichtung eingestellt wird.

Sofern eine Last an den Schutzschalter angeschlossen ist, wird die Last mit deren ersten Anschluss mit dem Lastanschluss verbunden, wobei deren zweiter Anschluss beispielsweise gegen ein Bezugspotential, wie Ground (GND) geführt ist.

Erfindungsgemäß wird in einem Verfahren zum Betrieb eines elektronischen Schutzschalters, welcher gemäß einer der oben dargestellten Varianten ausgeführt ist und entsprechend einen zwischen dem Spannungseingang und dem Lastausgang geschalteten ersten Halbleiterschalter aufweist, ein Ist-Wert des Laststroms bzw. der Laststrom als Ist-Wert erfasst. Des Weiteren wird in einem Kurzschlussfall bzw. bei Überschreiten eines Maximalwertes durch den Ist-Wert der Halbleiterschalter, insbesondere mittels der Abschaltschaltung (Einrichtung bzw. Schaltung zum Abschalten bzw. Stromsperren), abgeschaltet bzw. stromsperrend geschaltet. Im Überlastfall bzw. bei Überschreiten eines Soll-Wertes durch den Ist-Wert der Halbleiterschalter, insbesondere mittels der Strombegrenzungsschaltung (Einrichtung bzw. Schaltung zur Strombegrenzung), strombegrenzend geschaltet.

Gemäß einer vorteilhaften Weiterbildung wird im Kurzschlussfall der Sollwert des Laststroms auf einen Minimalwert, insbesondere Null, eingestellt. Beispielsweise wird hierzu der Kondensator des Einstellglieds entladen und anschließend insbesondere mittels Laden des Kondensators vorzugsweise kontinuierlich (graduell) auf den Nominal-Soll-Wert erhöht. Beispielsweise wird hierzu das Einstellglied herangezogen.

In einer vorteilhaften Ausgestaltung des Verfahrens wird ein Differenzwert aus dem Ist-Wert und dem Sollwert gebildet. Dieser Differenzwert, insbesondere im Überlastfall, als ein Steuersignal zur strombegrenzenden Ansteuerung des ersten Halbleiterschalters herangezogen. Zweckmäßigerweise wird hierzu der Operationsverstärker herangezogen.

Vorzugsweise wird der strombegrenzend gesteuerte erste Halbleiterschalter nach Ablauf einer vorgegebenen Zeitdauer bzw. eines vorgegebenen Zeitglieds stromsperrend geschaltet bzw. abgeschaltet und/oder entsprechend gesteuert. Mit anderen Worten wird der erste Halbleiterschalterschalter vorzugsweise stromsperrend geschaltet und/oder angesteuert, wenn die Strombegrenzung die vorgegebene Zeitdauer bzw. das Zeitglied seit Beginn der strombegrenzenden Ansteuerung, insbesondere ununterbrochen, angedauert hat.

Zusammenfassend liegen die Vorteile der Erfindung insbesondere darin, dass der elektronische Schutzschalter mittels der Steuervorrichtung, insbesondere mittels deren Abschaltschaltung im Kurzschlussfall vergleichsweise schnell erfolgt. Auf diese Weise sind Stromspitzen des Laststroms in Kurzschlussfall lediglich vergleichsweise gering, d.h. weisen eine vergleichsweise niedrige maximale Stromstärke auf, so dass eine Beschädigung einer an den Strompfad angeschlossene Last und/oder Spannungs- oder Stromquelle vermieden ist. Zudem ist aufgrund der vorteilhaft vergleichsweise geringen Stromspitzen im Kurzschlussfall eine Verwendung von überdimensionierten MOSFETs nicht notwendig, was kostensparend wirkt.

Nachfolgend werden Ausführungsbeispiele der Erfindung anhand einer Zeichnung näher erläutert. Darin zeigen:
- Fig. 1: in einem Strom-Zeit-Diagramm den zeitlichen Verlauf den Ausgangsstrom (Laststrom) eines elektronischen Schutzschalters gemäß dem Stand der Technik bei einem Kurzschluss,
- Fig. 2: in einem mit Fig. 1 korrespondierenden Spannungs-Zeit-Diagramm den Verlauf einer Versorgungsspannung einer Stromquelle bei einem Kurzschluss gemäß dem Stand der Technik,
- Fig. 3: schematisch einen zwischen einem Spannungseingang und einem Lastausgang geschalteten elektronischen Schutzschalter, welcher an dessen Steuereingang mit einer Steuervorrichtung verbunden ist, wobei die Steuervorrichtung eine Einrichtung zum Abschalten und eine Einrichtung zur Strombegrenzung aufweist,
- Fig. 4: in einem Blockschaltbild den elektronischen Schutzschalter mit einem in einen Strompfad geschalteten steuerbaren Halbleiterschalter sowie eine zu dessen Steuerung vorgesehenen und eingerichteten Steuervorrichtung,
- Fig. 5: in einem Flussdiagramm den Verfahrensablauf des Verfahrens zum Betrieb des elektronischen Schutzschalters,
- Fig. 6: in einem Strom-Zeit-Diagramm den zeitlichen Verlauf eines Ausgangsstroms (Laststroms) im Strompfad, in welchen der erfindungsgemäß ausgebildete elektronische Schutzschalter geschaltet ist, bei einem Kurzschluss, wobei der Laststrom mittels des erfindungsgemäßen elektronischen Schutzschalters zunächst stromsperrend und anschließend strombegrenzend geschaltet ist,
- Fig. 7: in einem mit Fig. 6 korrespondierendem Spannungs-Zeit-Diagramm den Verlauf der Versorgungsspannung der Stromquelle, wobei der erfindungsgemäße elektronische Schutzschalter zunächst stromsperrend und anschließend strombegrenzend geschaltet ist, und
- Fig. 8: in einem Strom-Zeit-Diagramm zeitliche Verläufe eines Ausgangsstroms (Laststroms) im Strompfad eines erfindungsgemäß ausgebildeten elektronischen Schutzschalters bei einem Kurzschluss für unterschiedlich ausgebildete Einstellglieder des elektrischen Schutzschalters, wobei der Laststrom, anschließend an ein Abschalten des elektronischen Halbleiterschalters strombegrenzend angesteuert ist, dass der Laststrom kontinuierlich erhöht wird.

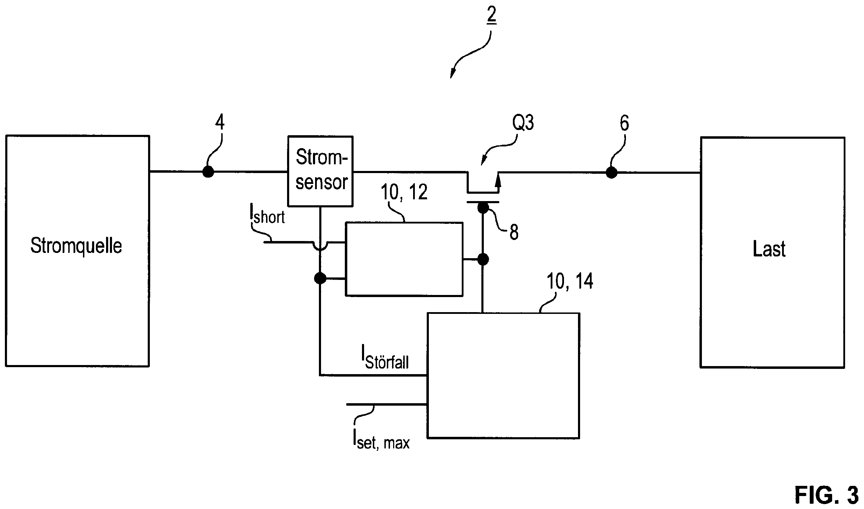

Fig. 3 zeigt einen zwischen einen elektronischen Schutzschalter 2 mit einem ersten Halbleiterschalter Q3, welcher in einem Strompfad 3 zwischen einem Spannungseingang 4 und einem Lastausgang 6 geschaltet ist. Der erste Halbleiterschalter Q3 ist an dessen Steuereingang 8 mit einer Steuervorrichtung 10 verbunden, wobei die Steuervorrichtung 10 eine Abschaltschaltung 12, auch als Einrichtung 12 zum Abschalten bezeichnet, und eine Strombegrenzungsschaltung 14, auch als Einrichtung 14 zur Strombegrenzung (Current limiting) aufweist. Die Abschaltschaltung 12 schaltet dabei den als einen MOSFET (Metall-Oxid-Halbleiter-Feldeffekttransistor, MOS-Transistor) ausgeführten ersten Halbleiterschalter Q3, insbesondere im Kurzschlussfall bzw. bei Bedarf ab, wobei das Abschalten vergleichsweise schnell zu einer Reaktionszeit einer herkömmlichen Strombegrenzungsschaltung erfolgt.

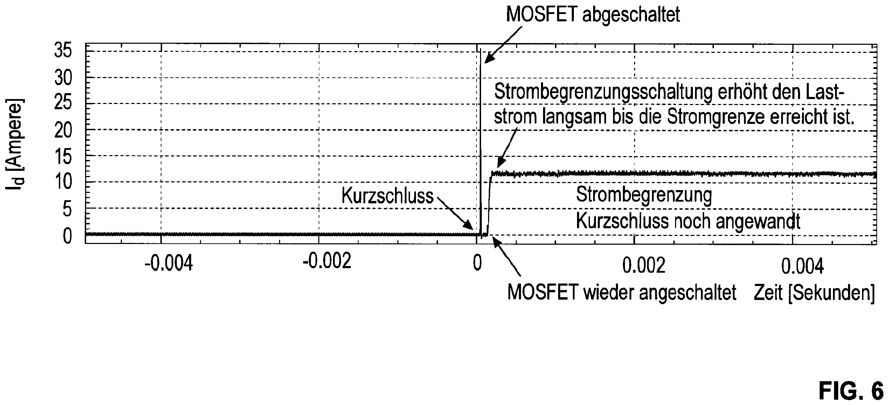

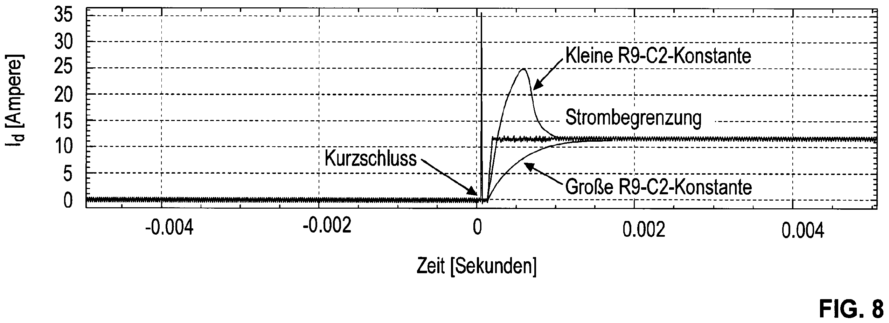

Des Weiteren ist beispielsweise die Strombegrenzungsschaltung 14 aus vergleichsweise kostensparenden Komponenten hergestellt und weist einen vergleichsweise stabile Regelung, insbesondere des Laststroms, auf. Wie insbesondere in den Figuren 6 und 8 erkennbar ist, treten aufgrund des vergleichsweise schnellen Abschaltens des ersten Halbleiterschalters Q3 lediglich vergleichsweise kleine Stromspitzen auf. So ist aufgrund der Steuervorrichtung 10 die Verwendung von solchen MOSFETS ermöglicht, welche lediglich vergleichsweise kleine Stromspitzen Rechnung tragen müssen, wodurch Kosten verringert und eine Zuverlässigkeit, beispielsweise bezüglich der Regelstabilität, erhöht sind.

Hierbei wird der erste Halbleiterschalter Q3 abgeschaltet (strombegrenzend geschaltet), sobald dessen Laststrom (Ausgangsstrom) einen, insbesondere einen Kurzschlussstrom repräsentierenden, Maximalwert Iₛₕₒᵣₜ überschreitet. Anschließend wird der erste Halleiterschalter Q3 strombegrenzend betrieben, wobei die Strombegrenzungsschaltung 14 den Laststrom I_{load}, insbesondere dessen Stromstärke, derart begrenzt, dass der Laststrom I_{load}, insbesondere dessen Stromstärke, graduell (kontinuierlich, vergleichsweise langsam ansteigend) von einem Minimalwert Iₘᵢₙ, insbesondere Null, auf eine Stromstärke bis zu einem Nominal-Sollwert I_{set,max} erhöht wird (Fig. 6). Dabei ist in der Fig. 6 der Laststrom I_{load} als I_{d} bezeichnet.

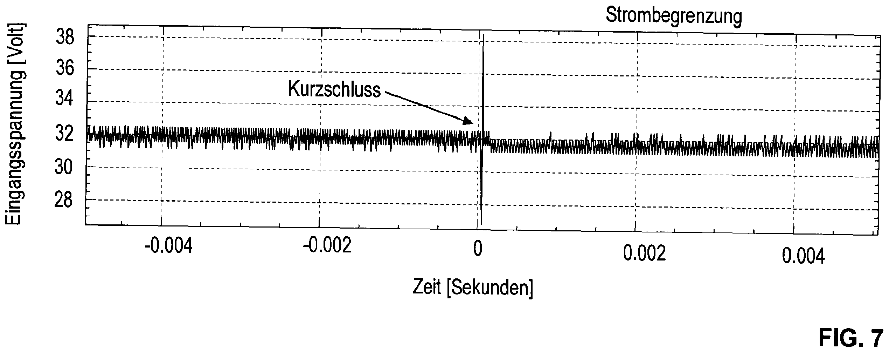

Wie in Fig. 6 und 7 dargestellt, sind Störungen der Versorgungsspannung, und somit insbesondere der Eingangsspannung, welche in Fig. 7als Input Voltage bezeichnet ist, sowie die Stromspitze bei Verwendung des erfindungsgemäßen elektronischen Schutzschalters 2 vergleichsweise klein zu Störungen der Versorgungsspannung und der Stromspitze bei Verwendung eines elektronischen Schutzschalters gemäß dem Stand der Technik (Fig. 1 und 2).

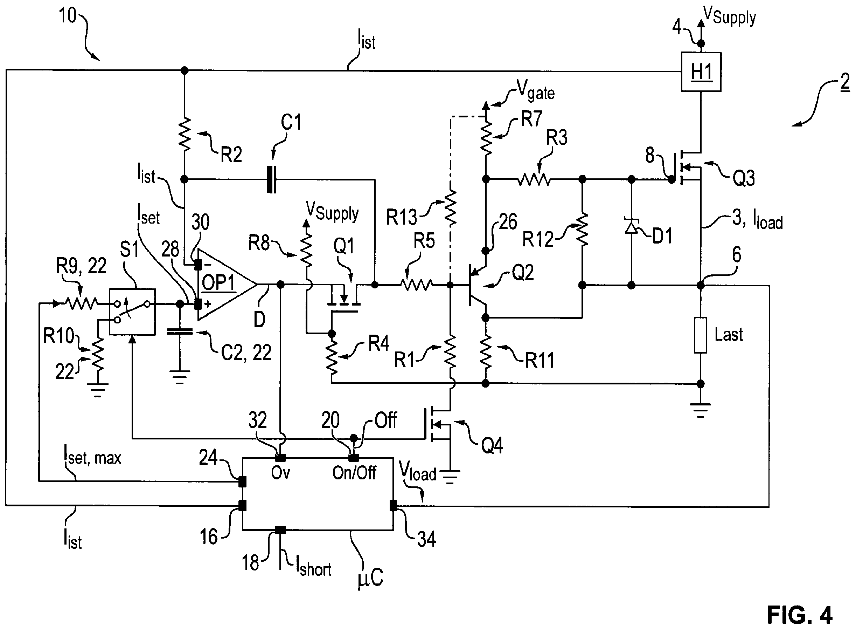

In Fig.4 ist ein Blockschaltbild des elektronischen Schutzschalters 2 dargestellt. Der Laststrom I_{load} wird mittels eines in den Strompfad 3 geschalteten Stromsensors H1 erfasst und als ein diesen Laststrom I_{load} repräsentierender Ist-Wert Iᵢₛₜ an die Steuervorrichtung 10, insbesondere an einen ersten Eingang (Pin) 16 einer Steuereinheit µC der Steuervorrichtung 10 ausgegeben. Der Ist-Wert Iᵢₛₜ ist dabei als eine Spannung oder ein Spannungssignal ausgebildet. Dabei weist der Stromsensor H1 zweckmäßigerweise eine Schaltgeschwindigkeit derart auf, dass vergleichsweise schnelle Änderungen, beispielsweise im Kurzschlussfall, des mittels diesem erfassten Stroms erfasst (aufgelöst) werden. Bei einem Kurzschluss, übersteigt der Ist-Wert Iᵢₛₜ den, insbesondere einem zweiten Eingang (Pin) 18 der Steuereinheit µC zugeführten, Maximalwert Iₛₕₒᵣₜ, so dass beispielsweise eine Unterbrechung in der Steuereinheit µC ausgelöst wird, und so dass die als ein Mikrocontroller ausgebildete Steuereinheit µC ein Signal Off, beispielswiese eine Spannung, an dessen ersten Ausgang 20 ausgibt, welches vorzugsweise bis zu einem Abschalten des Signals Off am Ausgang ausgegeben (angelegt) bleibt.

Alternativ ist in einer nicht weiter dargestellten Variante der Ist-Wert Iᵢₛₜ einem ersten Eingang eines zweiten, als Komparator ausgebildeten, Operationsverstärkers und der Maximalwert Iₛₕₒᵣₜ dem zweiten Eingang des zweiten Operationsverstärkers zugeführt. Der Ausgang des zweiten Operationsverstärkers ist dann mit einem Eingang der Steuereinheit µC verbunden. So wird bei Überschreiten des Maximalwert Iₛₕₒᵣₜ durch den Ist-Wert Iᵢₛₜ ein entsprechendes (Steuer- oder Spannungs-) Signal an diesen Eingang der Steuereinheit µC gegeben.

Der erste Ausgang 20 ist über einen vierten Halbleiterschalter Q4 mit einem zweiten Halbleiterschalter Q2 und parallel an einen Schalter S1 eines Einstellglieds 22 verbunden. Das Einstellglied 22 weist dabei einen Kondensator C2 auf, welcher in einer ersten Schalterstellung des Schalters S1 über einen Widerstand R9 an einem den Nominal-Soll-Wert I_{set,max} ausgebenden zweiten Ausgang 24 der Steuereinheit µC angeschlossen und in einer zweiten Schalterstellung des Schalter S2 über einen Widerstand R10 gegen Bezugspotential geführt ist.

Des Weiteren ist ein Spannungseingang V_{gate} über die Widerstände R7 und R3 an den Steuereingang 8 (das Gate) des ersten Halbleiterschalters Q3 verbunden. Mittels einer an diesem Spannungseingang V_{gate} anliegenden Spannung und der elektrischen Widerstände R7 und R3 ist der Arbeitspunkt des ersten Halbleiterschalters Q3 eingestellt.

Mittels einer Diode D1, welche in einen Strompfad, welcher zwischen dem Gate (Steuereingang 8) und der Source des ersten Halbleiterschalters Q3 verläuft, verbunden ist, wird die Spannung zwischen Gate und Source des ersten Halbleiterschalters Q3 begrenzt. Mittels des parallel zur Diode D1 geschalteten Widerstands R12 wird das Gate des ersten Halbleiterschalters Q3 entladen, wenn im Stromkreis keine Spannung anliegt.

Aufgrund des Signals Off wird der zweite Halbleiterschalter Q2 leitend geschaltet, dessen Ausgang 26 mit dem Steuereingang 8 des ersten Halbleiterschalters Q3 gekoppelt ist, so dass folglich der als Gate ausgebildete Steuereingang 8 des ersten Halbleiterschalter Q3 entladen wird. Der Laststrom I_{load} ist mittels des ersten Halbleiterschalter Q3 unterbrochen. Dieser Prozess ist innerhalb einer vergleichsweise kurzen Dauer realisiert, typischerweise 1-10 µs (Fig. 6). Zusätzlich, insbesondere gleichzeitig, wird das Signal an einen Schalter S1 ausgegeben. Dieser ist folglich derart geschaltet, dass der Kondensator C2 über den Widerstand R10 entladen wird.

Zusammenfassend wird der erste Halbleiterschalter Q3 mittels des zweiten Halbleiterschalters Q2 angesteuert. Die Widerstände R3, R5, R7, R11 und R12 dienen dabei zur Einstellung des Betrags der am Steuereingang 8 ersten Halbleiterschalter Q3 anliegenden Spannung.

Gemäß einer alternativen Ausgestaltung des elektronischen Schutzschalters 2 weist dieser zusätzlich einen Strompfad zwischen dem Spannungseingang V_{gate} und dem Steuereingang (der Basis) des zweiten Halbleiterschalters Q2 auf. In diesen Strompfad ist ein Widerstand R13 geschaltet. Dieser Strompfad ist in der Fig. 4 strichpunktiert dargestellt. Bei Ausgabe des Signals Off wird der vierte Halbleiterschalter Q4 derart, insbesondere leitend geschaltet, dass der erste Halbleiterschalter Q3 sperrend geschaltet wird. Insbesondere wird hierzu der vierte Halbleiterschalter Q4 leitend geschaltet, so dass die am Steuereingang 8 des ersten Halbleiterschalter Q3 anliegende Spannung entsprechend verringert ist.

Nach Ablauf einer vorgegebenen Zeitdauer, welche vorzugsweise derart ausgebildet ist, dass der Kondensator C2 sich gerade vollständig (komplett) entlädt, also einer Entladezeit des Kondensators C2 über den Widerstand R10 entspricht, wird das Signal Off abgeschaltet, so dass der Schalter S1 erneut in der ersten Schalterstellung ist und folglich der Kondensator C2 über den Widerstand R9 geladen wird.

Das Einstellglied 22 ist an einen ersten Eingang 28 eines Operationsverstärkers OP1 geschaltet und gibt einen Soll-Wert Iₛₑₜ, welcher mittels der am Kondensator C2 anliegenden Spannung repräsentiert ist, an diesen ersten Eingang 28 aus. An einen, insbesondere invertierenden, zweiten Eingang 30 des Operationsverstärkers ist der Ist-Wert Iᵢₛₜ zugeführt.

Dabei wird mittels der Operationsverstärkers OP1 eine Differenz aus Ist-Wert Iᵢₛₜ und Soll-Wert Iₛₑₜ gebildet. Diese Differenz wird als Steuersignal D vom Operationsverstärker OP1 ausgegeben. Mittels eines dritten Halbleiterschalters Q1 sowie mittels der Widerstände R4 und R8 ist ein Verstärker für das vom Operationsverstärker OP1 ausgegebene (Spannungs-) Signal D gebildet. Die Amplitude (der Betrag) des Signals D wird auf diese Weise auf eine zum Betrieb des zweiten Halbleiterschalters Q2, und somit für eine zur Ansteuerung des ersten Halbleiterschalters Q3, geeignete Amplitude geändert bzw. angepasst (verstärkt).

Beim Laden des Kondensators C2 über einen elektrischen Widerstand R 10 ändert sich entsprechend des Ladezustands des Kondensators C2 der an den ersten Eingang 28 geführte Soll-Wert Iₛₑₜ. Dies bewirkt eine entsprechende, insbesondere graduelle, Änderung des Signals D. Der zweite Halbleiterschalter Q2 wird somit derart, insbesondere graduell weniger leitend (stromsperrend), angesteuert, dass der erste Halbleiterschalter Q3, graduell (kontinuierlich), leitend geschaltet wird. Auf diese Weise steigt der Laststrom I_{load} graduell an, bis der an den ersten Eingang 16 der Steuereinheit µC zugeführte Ist-Wert Iᵢₛₜ dem Nominal-Soll-Wert I_{set,max} entspricht. Wie in Fig. 8 gezeigt ist, ist es ermöglicht, die Zeitdauer, in welcher Laststrom I_{load} steigt, mittels einer geeigneten Wahl des Widerstandswertes (Betrag des Widerstandes) des elektrischen Widerstands R9 und der Kapazität des Kondensators C2, also durch eine geeignete Ausbildung des Einstellglieds 22, zu bestimmen (vorzugeben). Hierbei ist der Laststrom mit I_{d} bezeichnet.

Ferner ist ein Kondensator C1 in einem zwischen den zweiten Eingang 30 des Operationsverstärkers OP1 und dessen Ausgang verlaufenden Strompfad geschaltet. Der Kondensator C1 weist dabei eine Kapazität auf, die geeignet ist, um eine Oszillation des Ausgangssignals des Operationsverstärkers OP1 und folglich im Strompfad 3 zu vermeiden.

Gemäß der Fig.4 umfasst die Abschaltschaltung 12 zusammenfassend einen elektrischen Widerstand R1 und den elektrischen Widerstand R10, den vierten Halbleiterschalter Q4, den Schalter S1, die Steuereinheit µC sowie gegebenenfalls den zweiten Operationsverstärker. Insbesondere wird der Laststrom I_{load} vorteilhaft unter Bildung einer Konstantstromquelle bei einer am Strompfad 3 angelegten Spannung mittels der elektrischen Widerstände R2 bis R5 und den elektrischen Widerständen R7 bis R9, R11 und R12, mittels der Kondensatoren C1 und C2, mittels des Operationsverstärkers OP1, mittels der Halbleiterschalter Q1, Q2 und Q3, mittels der Diode D1 sowie mittels des Stromsensors H1 geregelt, insbesondere konstant gehalten.

Zusätzlich wird das als Steuersignal D ausgeführte Ausgangssignal des Operationsverstärkers OP1, welches insbesondere als Ausgangsspannung ausgebildet ist, einem dritten Eingang 32 der Steuereinheit µC zugeführt, so dass die Steuereinheit µC mittels dieses Signals feststellt, ob noch eine Strombegrenzung des Laststroms I_{load} mittels des ersten Halbleiterschalters Q3 stattfindet. Um eine thermische Beschädigung, insbesondere des ersten Halbleiterschalters Q3, zu verhindern, wird der erste Halbleiterschalter Q3 stromsperrend geschaltet (abgeschaltet), wenn die Strombegrenzung eine vorgegebenen Zeitdauer seit Beginn der strombegrenzenden Ansteuerung, insbesondere ununterbrochen, angedauert hat. Des Weiteren ist eine an der Last (Load) anliegende Spannung V_{load} an einen vierten Eingang 34 der Steuereinheit µC zugeführt.

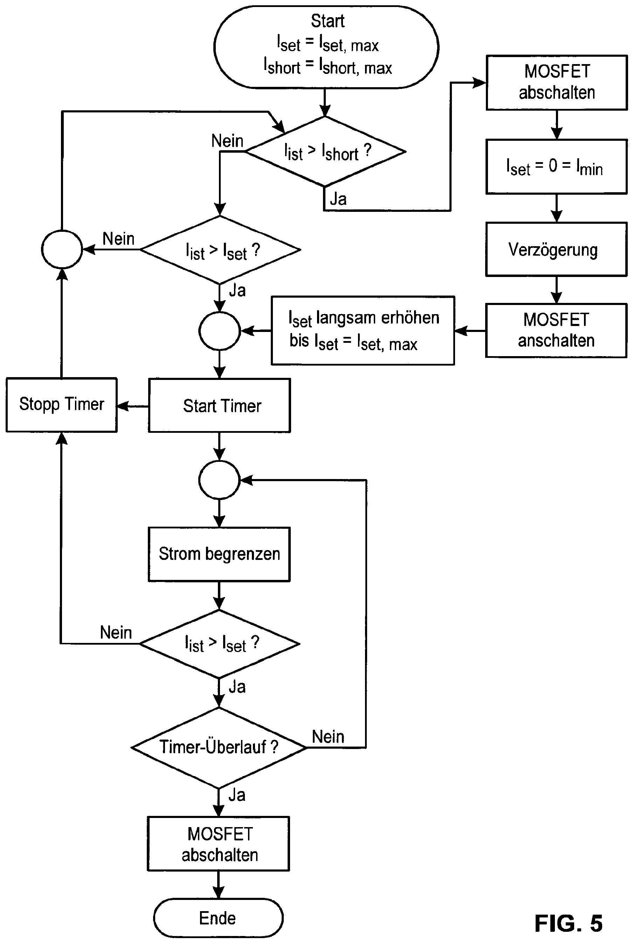

Der oben beschriebene Verfahrensablauf des Verfahrens zum Betrieb des elektronischen Schutzschalters 2 ist zusammenfassend im Flussdiagramm der Fig. 5 dargestellt. Des Weiteren ist zu erkennen, dass der erste Halbleiterschalter Q3 ebenfalls bei Überschreiten des Nominal-Soll-Wertes I_{set,max} durch den Ist-Wert Iᵢₛₜ strombegrenzend angesteuert wird, der Maximalwert Iₛₕₒᵣₜ allerdings nicht überschritten wird.

Zusammenfassend weist der elektronische Schutzschalter 2 einen ersten Halbleiterschalter Q3, vorzugsweise einen N-Kanal-MOS-Transistor, auf, der in einen Strompfad 3 zwischen einem Spannungseingang 4 und einem Lastausgang 6 geschaltet ist. Des Weiteren weist der elektronische Schutzschalter 2 eine mit dem Steuereingang 8 des ersten Halbleiterschalters Q3 verbundene Steuervorrichtung 10 auf, wobei der erste Halbleiterschalter Q3 in Abhängigkeit eines der Steuervorrichtung 10 zugeführten Ist-Wertes Iᵢₛₜ des Laststroms I_{load} angesteuert ist. Gemäß einer zweckmäßigen Weiterbildung weist die Steuervorrichtung 10 eine Steuereinheit µC aufweist.

In zweckmäßiger Ausgestaltung weist der elektronische Schutzschalter fernen einen Stromsensor H1 auf, der vorzugsweise in den Strompfad 3 geschaltet ist.

In vorteilhafter Ausgestaltung weist die Steuervorrichtung 10 eine Einrichtung bzw. Schaltung 14 zur Strombegrenzung sowie eine Einrichtung bzw. Schaltung 12 zum Abschalten bzw. zur Stromsperrung des ersten Halbleiterschalters Q3 auf.

In weiterer vorteilhafter Ausgestaltung ist der erste Halbleiterschalter Q3 in Abhängigkeit eines der Steuervorrichtung 10, der Einrichtung bzw. Schaltung 14 zur Strombegrenzung und/oder der Einrichtung bzw. Schaltung 12 zum Abschalten zugeführten Ist-Wertes Iᵢₛₜ des Laststroms I_{load} angesteuert.

Gemäß einer geeigneten Ausgestaltung des elektronischen Schutzschalters gibt die Steuervorrichtung 10 bzw. die Steuereinheit µC im Kurzschlussfall und/oder bei Überschreiten eines Maximalwertes Iₛₕₒᵣₜ durch den Ist-Wert Iᵢₛₜ ein Signal Off, insbesondere ein Abschaltsignal, an die Einrichtung bzw. Schaltung 14 zur Strombegrenzung und/oder vorzugsweise an die Einrichtung bzw. Schaltung 12 zum Abschalten zum Sperren und/oder Abschalten des ersten Halbleiterschalters Q3 aus.

In weiterer vorteilhafter Ausgestaltung des elektronischen Schutzschalters ist der Steuervorrichtung 10 bzw. der Einrichtung bzw. Schaltung 14 zur Strombegrenzung eingangsseitig der Ist-Wert Iᵢₛₜ und/oder der Einrichtung bzw. Schaltung 14 zur Strombegrenzung eingangsseitig insbesondere von der Steuereinheit µC, ein Nominal-Soll-Wert I_{set,max} zugeführt.

In weiterer vorteilhafter Ausgestaltung ist oder wird in Abhängigkeit des Ist-Werts Iᵢₛₜ und/oder des Nominal-Soll-Werts I_{set,max} der erste Halbleiterschalter Q3 strombegrenzend angesteuert.

Gemäß einer geeigneten Weiterbildung weist die Steuervorrichtung 10 bzw. der Einrichtung bzw. Schaltung 14 zur Strombegrenzung ein Einstellglied 22 aufweist. Dem Einstellglied 22 ist geeigneter Weise der Nominal-Soll-Wert I_{set,max} eingangsseitig zugeführt, und es gibt ausgangsseitig einen Soll-Wert Iₛₑₜ aus.

In geeigneter Ausgestaltung weist die Steuervorrichtung 10 bzw. das Einstellglied 22 einen Kondensator C2 auf. Der Kondensator C2 ist zweckmäßigerweise mittels eines Schalters S1 mit der Steuervorrichtung 10, insbesondere mit der Steuereinheit µC, gekoppelt oder wird mittels des Schalters S1 entladen.

In weiterer vorteilhafter Ausgestaltung weist die Steuervorrichtung 10 bzw. die Einrichtung bzw. Schaltung 14 zur Strombegrenzung 14 einen Operationsverstärker OP1 auf. Zweckmäßigerweise ist an einem ersten Eingang 28 des Operationsverstärkers OP1 das Einstellglied 22 zum Zuführen des Soll-Wertes Iₛₑₜ angeschlossen, und an einem zweiten Eingang des Operationsverstärkers OP1 ist der Ist-Wert Iᵢₛₜ zugeführt. Vorteilhafterweise wird mittels des Operationsverstärkers OP1 ein Steuersignal D zum Ansteuern des ersten Halbleiterschalters Q3, insbesondere eine Differenz aus Sollwert Iₛₑₜ und Ist-Wert Iᵢₛₜ, gebildet. Zudem ist geeigneter Weise der Steuervorrichtung 10 bzw. der Steuereinheit µC eine Lastspannung V_{load} zugeführt.

In zweckmäßiger Ausgestaltung weist die Steuervorrichtung 10, die Einrichtung bzw. Schaltung 14 zur Strombegrenzung und/oder die Einrichtung bzw. Schaltung 12 zum Abschalten einen zweiten Halbleiterschalter Q2, vorzugsweise einen pnp-Bipolartransistor, auf. In zweckmäßiger Ausgestaltung ist der zweite Halbleiterschalter Q2 an den Steuereingang 8 des ersten Halbleiterschalters Q3 angeschlossen. In weiterer geeigneter Ausgestaltung bildet der Ausgang 26 des zweiten Halbleiterschalters Q2 vorzugsweise einen Ausgang der Einrichtung bzw. Schaltung 14 zur Strombegrenzung und/oder der Einrichtung bzw. Schaltung 12 zum Abschalten.

In geeigneter Ausgestaltung liegt der erste Halbleiterschalter Q3 drain-seitig vorzugsweise am Spannungseingang 4, source-seitig vorzugsweise am Lastausgang 6 und gate-seitig an der Steuervorrichtung 10.

Bei dem Verfahren zum Betrieb des elektronischen Schutzschalters 2 in einer der oben beschriebenen Varianten mit einem zwischen einen Spannungseingang 4 und einen Lastausgang 6 geschalteten ersten Halbleiterschalter Q3, wird verfahrensgemäß ein Ist-Wert Iᵢₛₜ des Laststroms I_{load} bzw. dieser als Ist-Wert Iᵢₛₜ erfasst, im Kurzschlussfall bei Überschreiten eines Maximalwertes Iₛₕₒᵣₜ durch den Ist-Wert Iᵢₛₜ der erste Halbleiterschalter Q3 stromsperrend geschaltet, und/oder im Überlastfall bei Überschreiten eines Sollwertes Iₛₑₜ durch den Ist-Wert Iᵢₛₜ der erste Halbleiterschalter Q3 strombegrenzend geschaltet.

In vorteilhafter Ausgestaltung des Verfahrens wird im Kurzschlussfall der Sollwert Iₛₑₜ des Laststroms I_{load} auf einen Minimalwert Iₘᵢₙ eingestellt und anschließend kontinuierlich auf einen Nominal-Soll-Wert I_{set,max} erhöht. Zweckmäßigerweise wird eine Differenz (ein Differenzwert) aus dem Ist-Wert Iᵢₛₜ und dem Soll-Wert Iₛₑₜ gebildet. Vorteilhafterweise wird die Differenz (der Differenzwert) als Steuersignal D zur strombegrenzenden Ansteuerung des ersten Halbleiterschalters Q3 herangezogen. Der strombegrenzend gesteuerte erste Halbleiterschalter Q3 wird geeigneter Weise nach Ablauf einer vorgegebenen Zeitdauer und/oder eines vorgegebenen Zeitglieds stromsperrend geschaltet und/oder gesteuert.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

### Bezugszeichenliste

- 2: elektronischer Schutzschalter
- 3: Strompfad
- 4: Spannungseingang
- 6: Lastausgang
- 8: Steuereingang
- 10: Steuervorrichtung
- 12: Einrichtung zum Abschalten
- 14: Einrichtung zur Strombegrenzung
- 16: erster Eingang der Steuereinheit
- 18: zweiter Eingang der Steuereinheit
- 20: erster Ausgang der Steuereinheit
- 22: Einstellglied
- 24: zweiter Ausgang der Steuereinheit
- 26: Ausgang des zweiten Halbleiterschalters
- 28: erster Eingang des Operationsverstärkers
- 30: zweiter Eingang des Operationsverstärkers
- 32: dritter Eingang der Steuereinheit
- 34: vierter Eingang der Steuereinheit

- C1: Kondensator
- C2: Kondensator
- D: Steuersignal/Differenz
- D1: Diode
- H1: Stromsensor
- Iᵢₛₜ: Ist-Wert
- I_{load}: Laststrom
- Iₘᵢₙ: Minimalwert
- Iₛₑₜ: Soll-Wert
- I_{set,max}: Nominal-Soll-Wert
- Iₛₕₒᵣₜ: Maximalwert
- µC: Steuereinheit
- Off: Signal zum Abschalten
- OP1: Operationsverstärker
- Q1: dritter Halbleiterschalter
- Q2: zweiter Halbleiterschalter
- Q3: erster Halbleiterschalter
- Q4: vierter Halbleiterschalter
- R1 bis R13: elektrische Widerstände
- V_{load}: Lastspannung
- V_{gate}: Spannungseingang

## Patentansprüche

1. Elektronischer Schutzschalter (2), aufweisend
- einen ersten Halbleiterschalter (Q3), der in einen Strompfad (3) zwischen einem Spannungseingang (4) und einem Lastausgang (6) geschaltet ist, und
- eine mit dem Steuereingang (8) des ersten Halbleiterschalters (Q3) verbundene Steuervorrichtung (10),
- wobei der erste Halbleiterschalter (Q3) in Abhängigkeit eines der Steuervorrichtung (10) zugeführten Ist-Wertes (Iᵢₛₜ) des Laststroms (I_{load}) angesteuert ist,
- wobei die Steuervorrichtung (10) zur Strombegrenzung sowie zum Abschalten des ersten Halbleiterschalters (Q3) eingerichtet ist,
- wobei die Steuervorrichtung (10) eine Steuereinheit (µC) aufweist,
- wobei die Steuervorrichtung (10) bzw. die Steuereinheit (µC) bei Überschreiten eines Maximalwertes (Iₛₕₒᵣₜ) durch den Ist-Wert (Iᵢₛₜ) ein Signal (Off) an eine Strombegrenzungsschaltung (14) und/oder an eine Abschaltschaltung (12) zum Abschalten des ersten Halbleiterschalters (Q3) ausgibt,
**dadurch gekennzeichnet,**
- **dass** der Strombegrenzungsschaltung (14) eingangsseitig der Ist-Wert (Iᵢₛₜ) und ein Nominal-Soll-Wert (I_{set,max}) zugeführt ist,
- **dass** die Strombegrenzungsschaltung (14) ein Einstellglied (22) aufweist, welchem der Nominal-Soll-Wert (I_{set,max}) eingangsseitig zugeführt ist und welches ausgangsseitig einen Soll-Wert (Iₛₑₜ) ausgibt, wobei der erste Halbleiterschalter (Q3) in Abhängigkeit des Soll-Wertes (Iₛₑₜ) und des Ist-Wertes (Iᵢₛₜ) strombegrenzend angesteuert wird, und
- **dass** das Einstellglied (22) einen Kondensator (C2) aufweist, welcher mittels eines Schalters (S1) zur Zuführung des Nominal-Soll-Werts (I_{set,max}) mit der Steuereinheit (µC) gekoppelt ist oder mittels des Schalters (S1) entladen wird, wobei die am Kondensator (C2) anliegende Spannung den Soll-Wert (Iₛₑₜ) repräsentiert.

2. Elektronischer Schutzschalter (2) nach Anspruch 1, wobei der erste Halbleiterschalter (Q3) in Abhängigkeit des Ist-Werts (Iᵢₛₜ) und des Nominal-Soll-Werts (I_{set,max}) strombegrenzend angesteuert ist oder wird.

3. Elektronischer Schutzschalter (2) Anspruch 1 oder 2, wobei die Strombegrenzungsschaltung (14) einen Operationsverstärker (OP1) aufweist, an dessen ersten Eingang (28) das Einstellglied (22) zum Zuführen des Soll-Wertes (Iₛₑₜ) angeschlossen ist, und an dessen zweiten Eingang (30) der Ist-Wert (Iᵢₛₜ) zugeführt ist.

4. Elektronischer Schutzschalter (2) nach Anspruch 3, wobei der Operationsverstärkers (OP1) ein Steuersignal (D) zum Ansteuern des ersten Halbleiterschalters (Q3) bereitstellt.

5. Elektronischer Schutzschalter (2) nach einem der vorhergehenden Ansprüche, wobei die Steuervorrichtung (10), die Strombegrenzungsschaltung (14) und/oder die Abschaltschaltung (12) einen zweiten Halbleiterschalter (Q2) aufweist, welcher an den Steuereingang (8) des ersten Halbleiterschalters (Q3) angeschlossen ist.

6. Verfahren zum Betrieb eines nach einem der Ansprüche 1 bis 5 ausgebildeten elektronischen Schutzschalters (2) mit einem zwischen einen Spannungseingang (4) und einen Lastausgang (6) geschalteten ersten Halbleiterschalter (Q3),
- wobei ein Ist-Wert (Iᵢₛₜ) des Laststroms (h_{load}) bzw. dieser als Ist-Wert (Iᵢₛₜ) erfasst wird,
- wobei im Kurzschlussfall bei Überschreiten eines Maximalwertes (Iₛₕₒᵣₜ) durch den Ist-Wert (Iᵢₛₜ) der erste Halbleiterschalter (Q3) stromsperrend geschaltet wird, und
- wobei im Überlastfall bei Überschreiten eines Sollwertes (Iₛₑₜ) durch den Ist-Wert (Iᵢₛₜ) der erste Halbleiterschalter (Q3) strombegrenzend geschaltet wird.

7. Verfahren nach Anspruch 6, wobei im Kurzschlussfall der Sollwert (Iₛₑₜ) des Laststroms (I_{load}) auf einen Minimalwert (Iₘᵢₙ) eingestellt und anschließend kontinuierlich auf einen Nominal-Soll-Wert (I_{set,max}) erhöht wird.

8. Verfahren nach Anspruch 6 oder 7,
- wobei eine Differenz aus dem Ist-Wert (Iᵢₛₜ) und dem Soll-Wert (Iₛₑₜ) gebildet wird, und
- wobei die Differenz als Steuersignal (D) zur strombegrenzenden Ansteuerung des ersten Halbleiterschalters (Q3) herangezogen wird.

9. Verfahren nach einem der Ansprüche 6 bis 8, wobei der strombegrenzend gesteuerte erste Halbleiterschalter (Q3) nach Ablauf einer vorgegebenen Zeitdauer oder eines vorgegebenen Zeitglieds stromsperrend geschaltet oder gesteuert wird.

## Claims

1. Electronic circuit breaker (2), comprising
- a first semiconductor switch (Q3) connected in a current path (3) between a voltage input (4) and a load output (6), and
- a control device (10) connected to the control input (8) of the first semiconductor switch (Q3),
- wherein the first semiconductor switch (Q3) is controlled in dependence on an actual value (Iᵢₛₜ) of the load current (h_{ead}) supplied to the control device (10),
- wherein the control device (10) is configured for current limiting as well as for switching off the first semiconductor switch (Q3),
- wherein the control device (10) comprises a control unit (µC),
- wherein the control device (10) or respectively the control unit (µC) outputs a signal (Off) to a current limiting circuit (14) and/or to a switch-off circuit (12) for switching off the first semiconductor switch (Q3) when the actual value (Iᵢₛₜ) exceeds a maximum value (Iₛₕₒᵣₜ),
**characterized in**
- **that** the current limiting circuit (14) is supplied on the input side with the actual value (Iᵢₛₜ) and with a nominal setpoint value (I_{set,max}),
- **that** the current-limiting circuit (14) comprises an adjustment element (22), to which the nominal setpoint value (I_{set,max}) is supplied on the input side and which outputs a setpoint value (Iₛₑₜ) on the output side, wherein the first semiconductor switch (Q3) is actuated in a current-limiting state in dependence on the setpoint value (Iₛₑₜ) and the actual value (Iᵢₛₜ), and
- **that** the adjustment element (22) comprises a capacitor (C2) which is coupled to the control unit (µC) by means of a switch (S1) for supplying the nominal set value (_{Iset,max}) or is discharged by means of the switch (S1), wherein the voltage applied to the capacitor (C2) represents the setpoint value (Iₛₑₜ).

2. Electronic circuit breaker (2) according to claim 1, wherein the first semiconductor switch (Q3) is triggered in a current-limiting state as a function of the actual value (Iᵢₛₜ) and the nominal setpoint value (_{Iset,max}).

3. Electronic circuit breaker (2) Claim 1 or 2, wherein the current limiting circuit (14) comprises an operational amplifier (OP1), to the first input (28) of which the adjustment element (22) for supplying the setpoint value (Iₛₑₜ) is connected, and to the second input (30) of which the actual value (Iᵢₛₜ) is supplied.

4. Electronic circuit breaker (2) according to claim 3, wherein the operational amplifier (OP1) provides a control signal (D) for actuating the first semiconductor switch (Q3).

5. Electronic circuit breaker (2) according to one of the preceding claims, wherein the control device (10), the current limiting circuit (14) and/or the switch-off circuit (12) comprises a second semiconductor switch (Q2) which is connected to the control input (8) of the first semiconductor switch (Q3).

6. Method of operating an electronic circuit breaker (2) configured according to one of claims 1 to 5, comprising a first semiconductor switch (Q3) connected between a voltage input (4) and a load output (6),
- wherein an actual value (Iᵢₛₜ) of the load current (I_{load}) is recorded or respectively the load current (I_{load}) is recorded as an actual value (Iᵢₛₜ),
- wherein, in the event of a short circuit, when the actual value (Iᵢₛₜ) exceeds a maximum value (Iₛₕₒᵣₜ), the first semiconductor switch (Q3) is switched in a current-blocking state, and
- wherein, in the event of an overload, when the actual value (Iᵢₛₜ) exceeds a setpoint value (Iₛₑₜ), the first semiconductor switch (Q3) is switched to a current-limiting state.

7. Method according to claim 6, wherein, in the event of a short-circuit, the setpoint value (Iₛₑₜ) of the load current (I_{load}) is set to a minimum value (Iₘᵢₙ) and then continuously increased to a nominal setpoint value (_{Iset,max}).

8. Method according to claim 6 or 7,
- wherein a difference is formed from the actual value (Iᵢₛₜ) and the setpoint value (Iₛₑₜ), and
- wherein said difference is used as a control signal (D) for the current-limiting control of the first semiconductor switch (Q3).

9. Method according to one of claims 6 to 8, wherein the current-limiting controlled first semiconductor switch (Q3) is switched or controlled in a current-blocking state after a predetermined period of time or a predetermined time element has elapsed.

## Revendications

1. Disjoncteur électronique (2), comprenant
- un premier commutateur à semi-conducteur (Q3), qui est connecté dans un trajet de courant (3) entre une entrée de tension (4) et une sortie de charge (6), et
- un dispositif de commande (10) connecté à l'entrée de commande (8) du premier commutateur à semi-conducteur (Q3),
- dans lequel le premier commutateur à semi-conducteur (Q3) est commandé en fonction d'une valeur réelle (Iᵢₛₜ) du courant de charge (I_{load}) fournie au dispositif de commande (10),
- dans lequel le dispositif de commande (10) est conçu pour limiter le courant ainsi que pour couper le premier commutateur à semi-conducteur (Q3),
- dans lequel le dispositif de commande (10) comprend une unité de commande (µC),
- dans lequel le dispositif de commande (10) ou respectivement l'unité de commande (µC) délivre, en cas de dépassement d'une valeur maximale (Iₛₕₒᵣₜ) par la valeur réelle (Iᵢₛₜ), un signal (Off) à un circuit de limitation de courant (14) et/ou à un circuit de coupure (12) pour couper le premier commutateur à semi-conducteur (Q3),
**caractérisé en ce**
- **que** la valeur réelle (Iᵢₛₜ) et une valeur nominale de consigne (I_{set,max}) sont fournies au circuit de limitation de courant (14) du côté de l'entrée,
- **que** le circuit de limitation de courant (14) comprend un élément de réglage (22), auquel la valeur de consigne nominale (I_{set,max}) est fournie côté entrée et qui délivre côté sortie une valeur de consigne (Iₛₑₜ), dans lequel le premier commutateur à semi-conducteur (Q3) est commandé en limitation de courant en fonction de la valeur de consigne (Iₛₑₜ) et de la valeur réelle (Iᵢₛₜ), et
- **que** l'élément de réglage (22) comprend un condensateur (C2), qui est couplé à l'unité de commande (µC) au moyen d'un commutateur (S1) pour l'alimentation de la valeur de consigne nominale (I_{set,max}) ou qui est déchargé au moyen du commutateur (S1), dans lequel la tension appliquée au condensateur (C2) représente la valeur de consigne (Iₛₑₜ).

2. Disjoncteur électronique (2) selon la revendication 1, dans lequel le premier commutateur à semi-conducteur (Q3) est commandé en limitation de courant en fonction de la valeur réelle (Iᵢₛₜ) et de la valeur nominale de consigne (I_{set,max}).

3. Disjoncteur électronique (2) revendication 1 ou 2, dans lequel le circuit de limitation de courant (14) comprend un amplificateur opérationnel (OP1), à la première entrée (28) duquel est connecté l'élément de réglage (22) pour l'application de la valeur de consigne (Iₛₑₜ), et à la deuxième entrée (30) duquel est fournie la valeur réelle (Iᵢₛₜ).

4. Disjoncteur électronique (2) selon la revendication 3, dans lequel l'amplificateur opérationnel (OP1) fournit un signal de commande (D) pour commander le premier commutateur à semi-conducteur (Q3).

5. Disjoncteur électronique (2) selon l'une des revendications précédentes, dans lequel le dispositif de commande (10), le circuit de limitation de courant (14) et/ou le circuit de coupure (12) comprend un deuxième commutateur à semi-conducteur (Q2), qui est connecté à l'entrée de commande (8) du premier commutateur à semi-conducteur (Q3).

6. Procédé de fonctionnement d'un disjoncteur électronique (2) selon l'une des revendications 1 à 5, comprenant un premier interrupteur à semi-conducteur (Q3) connecté entre une entrée de tension (4) et une sortie de charge (6),
- dans lequel une valeur réelle (Iᵢₛₜ) du courant de charge (I_{load}) ou respectivement celui-ci est saisie comme valeur réelle (Iᵢₛₜ),
- dans lequel, en cas de court-circuit, lorsqu'une valeur maximale (Iₛₕₒᵣₜ) est dépassée par la valeur réelle (Iᵢₛₜ), le premier commutateur à semi-conducteur (Q3) est commuté en blocage de courant, et
- dans lequel, en cas de surcharge, lorsqu'une valeur de consigne (Iₛₑₜ) est dépassée par la valeur réelle (Iᵢₛₜ), le premier commutateur à semi-conducteur (Q3) est commuté de manière à limiter le courant.

7. Procédé selon la revendication 6, dans lequel, en cas de court-circuit, la valeur de consigne (Iₛₑₜ) du courant de charge (I_{load}) est réglée sur une valeur minimale (Iₘᵢₙ) et est ensuite augmentée en continu jusqu'à une valeur de consigne nominale (I_{set,max}).

8. Procédé selon la revendication 6 ou 7,
- dans lequel une différence entre la valeur réelle (Iᵢₛₜ) et la valeur de consigne (Iₛₑₜ) est formée, et
- dans lequel ladite différence est utilisée comme signal de commande (D) pour la commande de limitation de courant du premier commutateur à semi-conducteur (Q3).

9. Procédé selon l'une des revendications 6 à 8, dans lequel le premier commutateur à semi-conducteur (Q3) commandé par limitation de courant est commuté ou commandé pour bloquer le courant après l'écoulement d'une durée prédéterminée ou d'un élément de temps prédéterminé.
